(19)

Europäisches Patentamt
European Patent Office
Office européen des brevets

(11) **EP 3 637 487 A1**

(12) **EUROPEAN PATENT APPLICATION**

(43) Date of publication:
**15.04.2020 Bulletin 2020/16**

(21) Application number: **18199304.9**

(22) Date of filing: **09.10.2018**

(51) Int Cl.:
**H01L 41/113** (2006.01)      **H01L 41/083** (2006.01)

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **Nederlandse Organisatie voor toegepast-natuurwetenschappelijk onderzoek TNO 2595 DA 's-Gravenhage (NL)**

(72) Inventors:
- **SMITS, Edsger Constant Pieter 2595 DA 's-Gravenhage (NL)**
- **BARINK, Marco 2595 DA 's-Gravenhage (NL)**
- **VAN HECK, Gerardus Titus 2595 DA 's-Gravenhage (NL)**

(74) Representative: **V.O. P.O. Box 87930 Carnegieplein 5 2508 DH Den Haag (NL)**

(54) **SHEAR PIEZOELECTRIC TRANSDUCER**

(57)      A piezoelectric transducer (100) comprises a piezoelectric foil (10) with a piezoelectric material (M) exhibiting a shear piezoelectric effect (d14). An actuating structure (20) is configured to actuate the foil (10) with actuation forces (Fu,Fd) applied at respective actuation points (Au,Ad) in respective actuation directions (U,D) to bend the foil (10) along at least one bending direction (S1,S2) diagonal to a polarization direction (3) of the foil (10). Preferably, the foil (10) is wrapped around a flexible plate and actuated according to a saddle shape deformation, so the foil (10) is bent in two opposing bending directions (S1,S2), which are orthogonal to each other and both diagonal to the polarization direction (3).

FIG 1A

EP 3 637 487 A1

**Description**

TECHNICAL FIELD AND BACKGROUND

The present disclosure relates to a piezoelectric transducer configured to operate with materials exhibiting shear piezoelectricity.

The piezoelectric effect is generally understood as a phenomenon whereby electric charges and corresponding fields may accumulate in certain materials in response to applied mechanical stress. Conversely electric fields applied to a piezoelectric material may cause corresponding deformations. Piezoelectric materials can be used in various types of electromechanical transducers, e.g. in actuators which convert electrical signals into mechanical motion, or in sensors or energy harvesters converting mechanical stress into electrical signals or accumulated charges.

For example, Ando et al. [Japanese Journal of Applied Physics 51 (2012) 09LD14; DOI: 10.1143/JJAP.51.09LD14] describe a film sensor device fabricated by a piezoelectric Poly($_L$-lactic acid) Film (PLLA). As explained in the prior art, because a lactic acid monomer has an asymmetric carbon, it has chirality. If the $_L$-lactide is polymerized, then the PLA polymer is called an $_L$-type PLA or a poly($_L$-lactic acid) (PLLA); if the $_D$-lactide in PLA is polymerized, then the polymer is a $_D$-type PLA (PDLA). If these polymers undergo drawing or elongation, then they exhibit shear piezoelectricity. A PLLA crystal is denoted by the point group $D_2$ and has the piezoelectric constants $d_{14}$, $d_{25}$, and $d_{36}$. If an electric field is applied to PLLA, the shear strain is induced perpendicular to the field direction. For films with a uniaxial orientation, $d_{36}$ disappears. Thus, the piezoelectric constants of PLLA specified by $d_{14}$ and $d_{25}$ are set to $d_{25} = -d_{14}$ by symmetry.

There is an interest to use piezolectric polymers such as PLLA and/or PDLA realizing pressure sensors and other devices. However, due to the shear piezoelectric ($d_{14}$) properties, such devices may be difficult to trigger. One solution may be to cut the foil at a 45 degree angle with respect to the drawing direction and laminate the foil on a substrate which is actuated to bend. However, this may waste material and not provide optimal actuation.

There remains a need to improve material use and transducing efficiency of piezoelectric transducers with shear piezoelectric materials.

SUMMARY

Aspects of the present disclosure relate to a piezoelectric transducer comprising a piezoelectric foil with a piezoelectric material exhibiting a shear piezoelectric effect. Typically, such foil may generate an electric field in a field direction normal to the plane of the foil between a top surface and a bottom surface of the foil when the foil is sheared in plane of the foil in a shearing direction about the field direction. The transducer may comprise an actuating structure configured to actuate the foil with actuation forces applied at respective actuation points in respective actuation directions to bend the foil along at least one bending direction diagonal to the polarization direction of the foil. Preferably, the actuating structure is configured to actuate the foil according to a saddle shape deformation. For example, the surface of the deformed foil may have opposing curvatures in orthogonal bending directions. As will be further elucidated herein below with reference to the figures, this type of deformation may cause relatively uniform high shearing strain levels over a large part of the foil surface between the actuation points. Preferably, the foil is adhered on one or both sides of a flexible core plate. For example, the foil can be tightly wrapped around the core plate. This may improve the effect of stretching or compressing the foil. The foil does not need to be cut in a specified angle - it can be used a produced without additional cutting. It can just be laminated from the original roll, as it is bought. The horse saddle provides a simple and reliable approach. It does not require any complex load transfer mechanism to transfer the compressive load into a shear load. It may also provide one of the thinnest solution for this piezoelectric material to harvest reasonable amounts of electric energy. Advantageously, the foil at the top and bottom of the core plate may be loaded in the same way due to the typical symmetry of the saddle shape.

BRIEF DESCRIPTION OF DRAWINGS

These and other features, aspects, and advantages of the apparatus, systems and methods of the present disclosure will become better understood from the following description, appended claims, and accompanying drawing wherein:

FIG 1A schematically illustrates a perspective view of a piezoelectric material being bent;
FIG 1B illustrates a simulation of corresponding shear strain in such material;
FIG 2A schematically illustrates a foil, similar as FIGs 1A and 1B, but now from a top view for further comparing the unbent (flat) shape with the saddle shape during deformation;
FIG 2B schematically illustrates a cross-section view of the saddle shaped foil along the line of the first bending direction in FIG 2A;
FIG 2C schematically illustrates a cross-section view of the saddle shaped foil along the line of the second bending direction in FIG 2A;
FIGs 3A-3B schematically illustrate pieces foil on both sides of a flexible base plate;
FIG 4A and 4B schematically illustrate multiple layers of piezoelectric foil attached to a flexible base plate;
FIG 5A schematically illustrates a method of forming a transducer by adhering a piezoelectric foil to a flexible base plate;

FIG 5B schematically illustrates adhering the same type of foil at orthogonal polarization directions by crossing the foils;

FIG 6A schematically illustrates a transducer formed by a piezoelectric foil wrapped around a flexible base plate

FIG 6B schematically illustrates a stack of alternating piezoelectric layers and corresponding electrodes;

FIG 7A schematically illustrates an actuating structure for actuating the foil and/or flexible base plate;

FIG 7B illustrates a photograph of an extended sensor surface with multiple transducers.

DESCRIPTION OF EMBODIMENTS

Terminology used for describing particular embodiments is not intended to be limiting of the invention. As used herein, the singular forms "a", "an" and "the" are intended to include the plural forms as well, unless the context clearly indicates otherwise. The term "and/or" includes any and all combinations of one or more of the associated listed items. It will be understood that the terms "comprises" and/or "comprising" specify the presence of stated features but do not preclude the presence or addition of one or more other features. It will be further understood that when a particular step of a method is referred to as subsequent to another step, it can directly follow said other step or one or more intermediate steps may be carried out before carrying out the particular step, unless specified otherwise. Likewise it will be understood that when a connection between structures or components is described, this connection may be established directly or through intermediate structures or components unless specified otherwise.

The invention is described more fully hereinafter with reference to the accompanying drawings, in which embodiments of the invention are shown. In the drawings, the absolute and relative sizes of systems, components, layers, and regions may be exaggerated for clarity. Embodiments may be described with reference to schematic and/or cross-section illustrations of possibly idealized embodiments and intermediate structures of the invention. In the description and drawings, like numbers refer to like elements throughout. Reference numbers with and without an apostrophe ['] indicate the same element in their bent or flat shape, respectively. Relative terms such as up, down, left, right, as well as derivatives thereof should be construed to refer to the orientation as then described or as shown in the drawing under discussion. These relative terms are for convenience of description and do not require that the system be constructed or operated in a particular orientation unless stated otherwise.

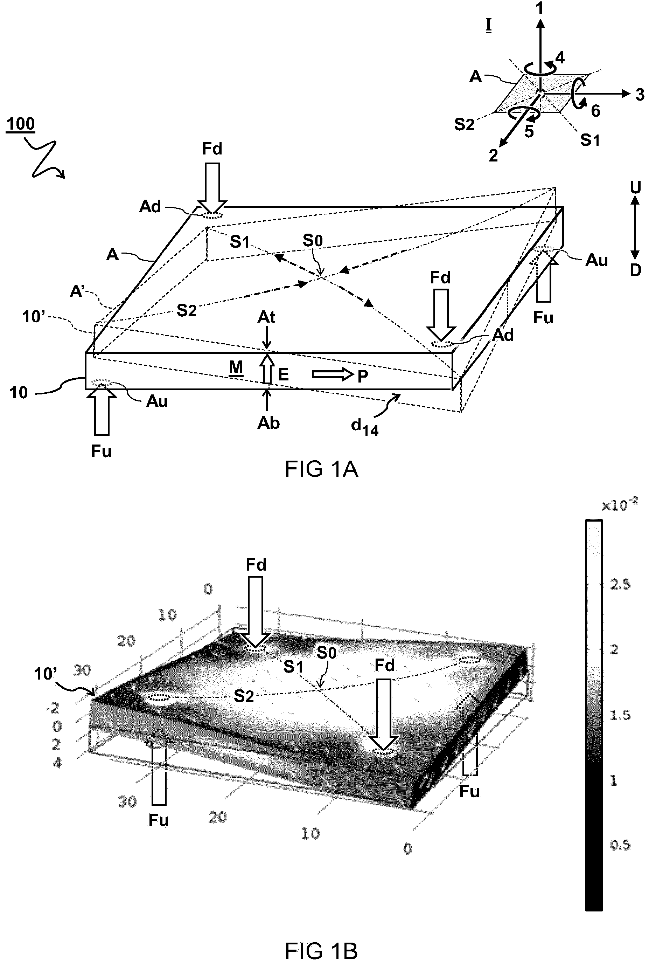

FIG 1A schematically illustrates bending of a piezoelectric material. The inset "I" indicated in FIG 1A (and other figures) shows a Cartesian coordinate system with orthogonal axes corresponding to thickness, width and length of the piezoelectric foil as depicted (here unbent). The inset "I" shown here also illustrates (principal) bending directions "S1" and "S2" relative to the plane "A" of the foil and the other axes.

As used herein, the reference numerals 1 through 6, indicate directions in a sequence of piezoelectric constants $d_{ab}$ as they conventionally appear in the piezoelectric tensor written as:

$$\begin{pmatrix} d_{11} & d_{12} & d_{13} & d_{14} & d_{15} & d_{16} \\ d_{21} & d_{22} & d_{23} & d_{24} & d_{25} & d_{26} \\ d_{31} & d_{32} & d_{33} & d_{34} & d_{35} & d_{36} \end{pmatrix}$$

In the tensor, the first subscript (1, 2, or 3) indicate respective directions of the electric field "E", and the second subscript (1, 2, 3, 4, 5, or 6) indicates the direction or type of deformation. The first three directions (1, 2, 3) correspond to expansion/contraction of the piezoelectric material along the respective axes, while the second three directions (4, 5, 6) correspond to shear deformations about the respective axes (conventionally indicated by a circular arrow around the respective axis 1, 2, 3).

As also mentioned in the prior art of the background section, a piezoelectric material which can be described by the point group $D_2$ has piezoelectric constants $d_{14}$, $d_{25}$, $d_{36}$. More specifically, for piezoelectric material having a uniaxial orientation, $d_{36}$ disappears and $d_{25} = -d_{14}$. For example, the piezoelectric tensor of PLLA or other suitable film can be written as

$$\begin{pmatrix} 0 & 0 & 0 & d_{14} & 0 & 0 \\ 0 & 0 & 0 & 0 & -d_{14} & 0 \\ 0 & 0 & 0 & 0 & 0 & 0 \end{pmatrix}$$

As described herein, in a piezoelectric material "M" exhibiting a shear piezoelectric effect, e.g. having nonzero piezoelectric constant ($d_{14}$), a shearing deformation (indicated by numeral 4) about (transverse to) the 1-axis may result in an electric field "E" along the 1-axis. The direction of the field along the 1-axis may depend on a sign of the piezoelectric constant $d_{14}$ and/or shearing direction 4. The process may also be work in reverse. So, if an electric field "E" is applied to the piezoelectric material "M" along the 1-axis, this may result in the corresponding shearing deformation 4. In some embodiments, the piezoelectric material "M" which is used, only has a shear piezoelectric effect, e.g. zero piezoelectric constants everywhere except $d_{14}$ (and by symmetry $d_{41}$), which can make it difficult to actuate.

In a one embodiment, e.g. as shown, a piezoelectric transducer 100 comprises a piezoelectric foil 10 with a piezoelectric material "M" exhibiting a shear piezoelectric effect $d_{14}$. Typically the piezoelectric material "M" is polarized "P" in a polarization or drawing direction 3 in plane "A" with the foil 10 to generate an electric field

"E" in a field direction 1 normal to the plane "A" of the foil 10 between a top surface "At" and a bottom surface "Ab" of the foil 10 when the foil 10 is sheared in plane "A" of the foil 10 in a shearing direction 4 about the field direction 1.

In some embodiments, the transducer 100 comprises an actuating structure (not shown here) configured to actuate the foil 10. In a preferred embodiment, the actuating structure is configured to engage the foil with actuation forces "Fu" and "Fd" applied at respective actuation points "Au" and "Ad" in respective actuation directions "U" and "D" to bend the foil 10 along at least one bending direction "S1" and/or "S2". Most preferably, the bending direction(s) are diagonal to the polarization direction 3 or drawing direction of the foil 10, as shown. For example, the bending direction(s) are at or near an angle of 45 degrees (e.g. within plus-minus ten or five degrees) with respect to the polarization direction 3.

In a preferred embodiment, the actuating structure is configured to actuate the foil 10 according to a saddle shape deformation. For example, the foil 10 is bent in two opposing bending directions "S1" and "S2", as shown. Most preferably, the two bending directions "S1" and "S2" are orthogonal to each other and both diagonal to the polarization direction 3. In the embodiment shown, the surface of the deformed foil 10' has opposing curvatures in orthogonal directions (S1,S2). The shape of such surface is generally described as a (horse) saddle or hyperbolic paraboloid. For example, a saddle point or minimax point is generally understood as a point on a surface where the slopes (derivatives) of respective functions describing the height of the surface in orthogonal directions are both zero (critical point), but which is not a local extremum of the function. In a saddle shape deformation, as described herein for some embodiments, a saddle point "S0" may be formed on the surface of the foil 10 where there is a critical point with a relative maximum along a first bending direction "S1" between valleys (of the downward actuation points "Ad") where the foil is pushed or held in one direction "D", and with a relative minimum along the crossing (orthogonal) axis of the second bending direction "S2" between peaks (of the upward actuation points "Au") where the foil is pushed or held in the opposing direction "U".

FIG 1B illustrates a simulation of shear strain in a piezoelectric material (Von Mises stress) when it is actuated as shown in FIG 1A. The simulation illustrates with grayscale the relative strain at different locations of the foil 10' during saddle shape deformation as shown. From the figure, it will be appreciated that this type of deformation may cause relatively uniform high shearing strain levels over a large part of the foil surface between the actuation points.

With reference again to FIG 1A, some embodiments comprise an actuating structure (not shown) configured to apply a first set of actuation forces "Fu" in a first actuation direction "U" normal to the plane "A" of the foil 10, and a second set of actuation forces "Fd" in a second actuation direction "D" opposite (but parallel) to the first actuation direction "U". For example, as shown, the first set of actuation forces "Fu" is applied to a first set of actuation points "Au" defining the first bending direction "S1" there between, wherein the second set of actuation forces "Fd" is applied to a second set of actuation points "Ad" defining the second bending direction "S2" there between, wherein the second bending direction "S2" crosses (orthogonally) with the first bending direction "S1" at a saddle point "S0" of the actuated foil 10'. Preferably, each set of actuation points comprises at least two separate or distinct points where the actuating structure engages the foil. In other words, there may be a region between the actuation points (having the same direction) which is not actuated or engaged by the actuating structure.

In these and other figures, as shown, bending directions "S1" and "S2" are indicated by respective (dash-dotted) lines wherein a curvature of the respective line illustrates a curvature of the foil 10 in the respective bending direction. Of course also other conventions with regards to the indication of a bending direction may be applied with similar result. For example, an alternative way of indicating a bending direction (not used here) may be to specify an axis around which the foil is bent. Also in that case, two orthogonal bending directions may be identified.

In the figures, the directions "U" and "D" may indicate an upward or downward direction with respect to the relative orientation of the foil 10 as depicted. Similarly, the orientation of the forces "Fu" and "Fd" may be upward and downward. Of course the orientations may change depending on the operation of the device, e.g. the rotation of the plane "A" of the foil 10. Furthermore, while the figure shows upward forces "Fu" applied to a set of actuation points "Au" pushing against the bottom surface "Ab" of the foil, alternatively, the same or similar forces may be applied by pulling at the top surface "At" of the foil 10. Similar considerations may also apply to the downward forces shown. Also combinations of pulling and pushing forces can be used.

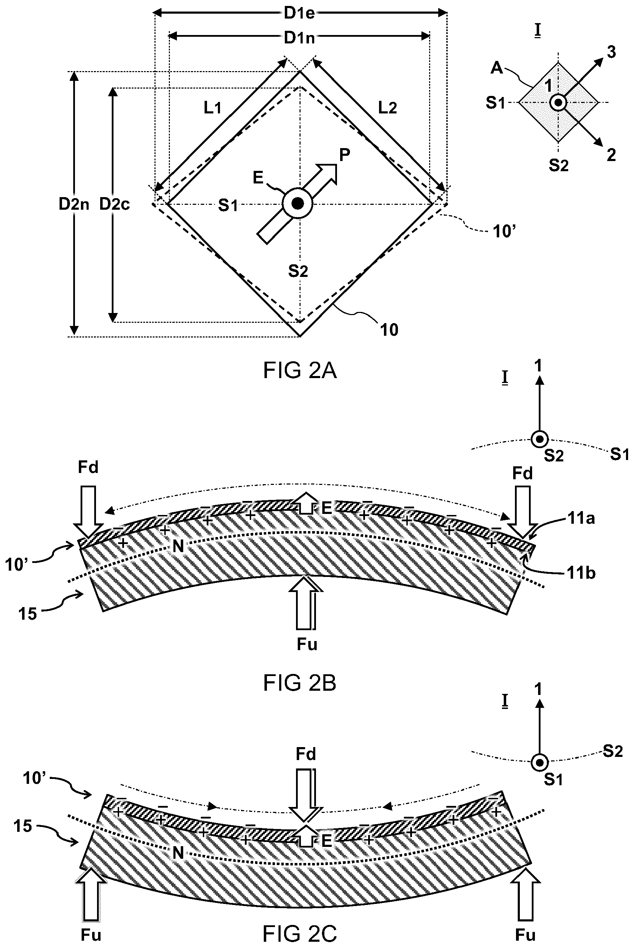

FIG 2A schematically illustrates a foil 10, similar as FIGs 1A and 1B, but now in a top view for further comparing the unbent (flat) shape with the saddle shape during deformation. The solid outline indicates the unbent shape of the foil 10, while the dashed outline indicates the bent shape of the foil 10'. The inset "I" indicates the orientation of the depicted foil.

In one embodiment, as shown, during saddle shape deformation, the deformed foil 10' is elongated along the first bending direction "S1" and compressed along the second bending direction "S2" compared to the flat foil 10. In some embodiments, the foil is elongated from an original first length "D1n" along the first bending direction "S1" to an elongated first length "D1e" along the first bending direction "S1". For example, the elongated first length "D1e" is higher than the original first length "D1n" by at least a factor 1.01 (one percent), preferably at least a factor 1.02 (two percent), more preferably at least a factor 1.05 (five percent), or more, e.g. between 1.1 and 1.3. In other or further embodiments, the foil is compressed from an original second length "D2n" along the second bending direction "S2" to a compressed second length "D2c" along the second bending direction "S2". For example, the original second length "D2n" is higher than the compressed second length "D2c" by at least a factor 1.01 (one percent), preferably at least a factor 1.02 (two percent), more preferably at least a factor 1.05 (five percent), or more, e.g. between 1.1 and 1.3. In a preferred embodiment of a saddle shape deformation, as shown, the foil 10 may experience both elongation along one direction and compression along another, transverse, direction. It will be appreciated that the combined deformation may enhance the effect of shear deformation compared e.g. to simple bending in only one of the directions. Accordingly, the saddle shape deformation may increase efficiency.

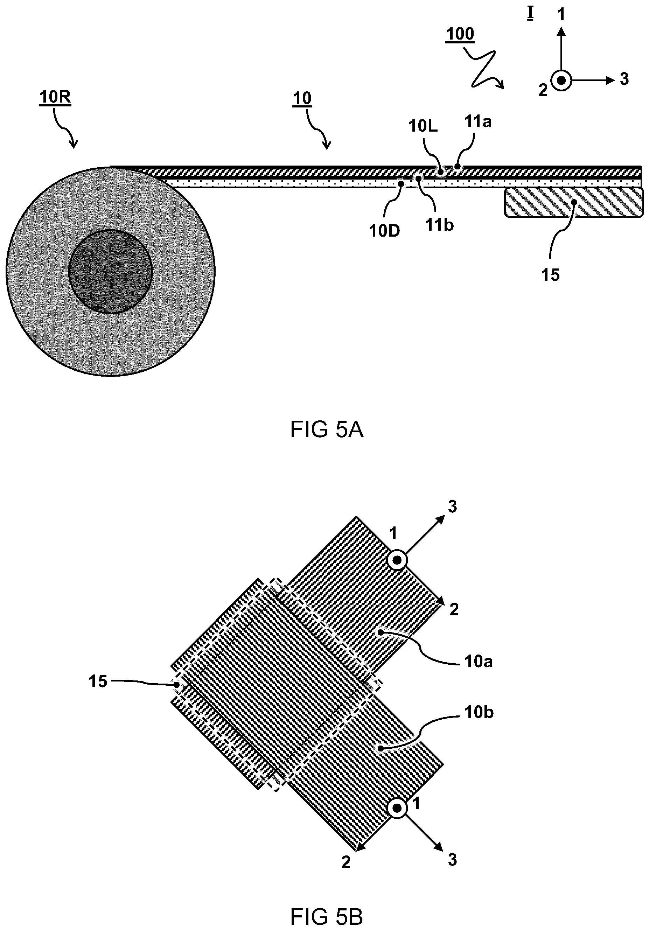

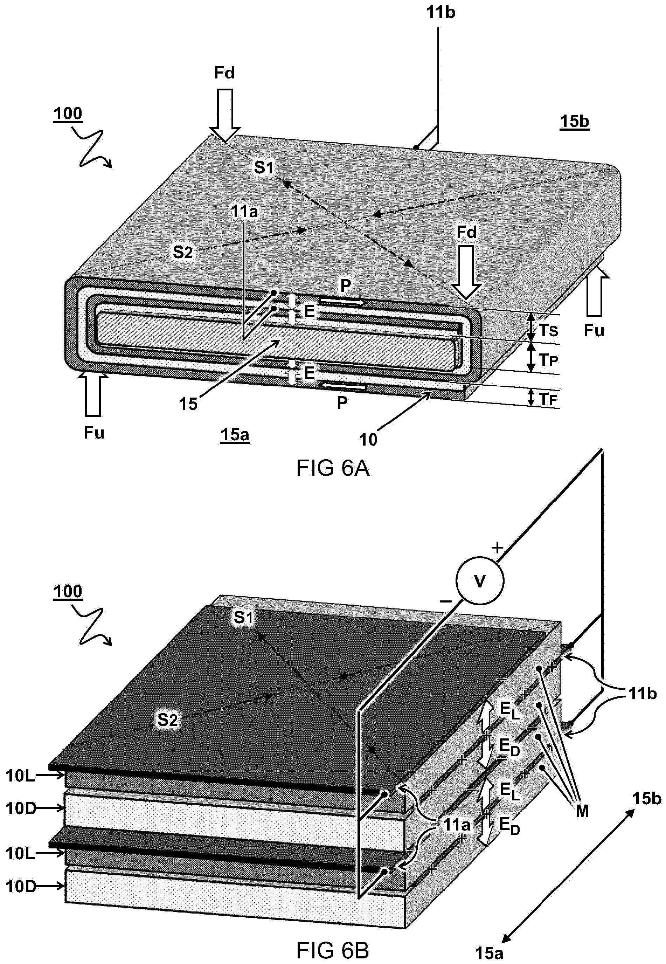

In a preferred embodiment, the polarization direction 3 is along a length L1 of the (unbent) foil, wherein the foil 10 is cut or folded back on itself (possibly with a plate there between) along a width L2 of the foil by a cut or fold line which is orthogonal to the length L1 of the foil. For example, the length side L1 of the foil 10 is formed by the sides of the extended foil, e.g. as provided from a roll, while the width side S2 of the foil 10 is formed by a straight cut or fold(s) of the foil transverse to its length. This is also referred to as a zero degree cut. It will be appreciated that this may be more convenient and/or waste less material than a 45 degree cut. Also, the zero degree (transverse) fold may be more convenient for forming a whole stack of foils as will be described later with reference to FIGs 5 and 6.

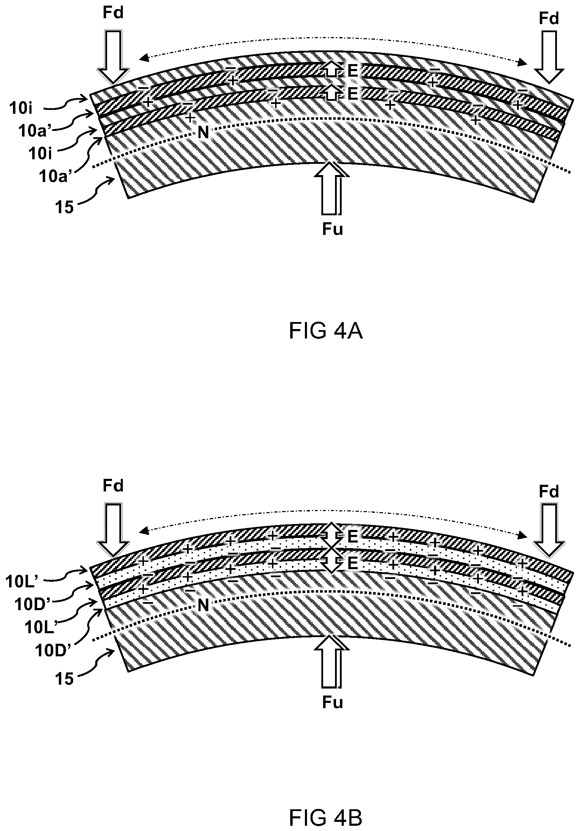

In some embodiments, the foil 10 is polarized by drawing or extruding the foil 10 along its length L1. For example, the foil 10 comprises a piezoelectric elongate molecules, e.g. polymers. For example, the elongate molecules may align with the drawing direction. Typically, piezoelectric polymers are chiral molecules, which may have different isomers. In some embodiments, the foil 10 comprises the same isomers in each layer, e.g. all $_L$-isomer (left handed) or all $_D$-isomer (right handed). In other or further embodiments, as will be described with reference to FIG 4B later, the foil may comprise a stack of different isomers in different layers.

In a preferred embodiment, one or more bending directions "S1" and/or "S2" are oriented along (crossing) diagonals of the foil 10. For example, the foil forms a rectangular surface, so the bending directions "S1" and "S2" can be along the diagonals of the rectangle (from corner to corner). More preferably, the foil forms a square surface, so the so the bending directions "S1" and "S2" can be along the diagonals of the square (from corner to corner) and orthogonally cross in the middle at or near ninety degrees. A rectangular shape is generally understood as a quadrilateral with all four angles right angles. A square shape is generally understood as a quadrilateral with all four angles right angles and all four sides of the same length. So a square can be considered as a special kind of rectangle. In some embodiments, the foil 10 is cut or folded to provide one or more rectangular and/or square surfaces, wherein the lengths of the sides "L1" and "L2" are similar or the same, e.g. differ by less than a factor 1.5, 1.3, 1.1, 1.05, or less. The more similar the sides "L1" and "L2" of the rectangle, the closer the bending along the diagonals may be at a desired angle with respect to the polarization direction 3 (e.g. at or near 45 degrees with respect to the polarization direction 3).

FIG 2B illustrates a cross-section view of the saddle shaped foil 10' along the line of the first bending direction "S1" in FIG 2A;

FIG 2C illustrates a cross-section view of the saddle shaped foil 10' along the line of the second bending direction "S2" in FIG 2A.

In some preferred embodiments, as shown, the piezoelectric foil 10 is adhered to a flexible plate 15. Preferably, the flexible plate 15 is sufficiently flexible to bend together with the foil 10. For example, the flexible plate comprises a bendable piece of plastic such as polystyrene or other (preferably non-conductive, electrically insulating) material. Preferably, the adhesion or connection between the surfaces of the foil 10 and plate 15 is sufficient to substantially prevent the foil 10 from slipping or sliding over the plate 15 when they are bent together. In some embodiments, sufficient adhesion may be provided by friction, e.g. when the foil is tightly wrapped or wound around the plate as will be described later. In other or further embodiments, adhesion may be provided by an adhesion layer, e.g. glue. Similar considerations with regards to friction and/or adhesion may also apply to the connection between the surfaces of different layers of foil.

In some embodiments, e.g. as shown, a respective neutral axis "N" for bending a combined stack comprising one or more layers of foil 10 adhered the flexible plate 15 along the first and/or second bending directions "S1" and "S2" lies within the flexible plate 15, preferably at or near a center of the plate 15. A neutral axis "N", also referred to as neutral bending line or neutral bending plane, is generally understood as the axis, line or plane in the cross section of a member (resisting bending), along which there are no longitudinal stresses or strains. For example, a position of the neutral axis "N" is indicated in FIGs 2B and 2C. For the first bending direction "S1" depicted in FIG 2B, there is a tensile (positive) strain on the foil 10 above the neutral axis "N", while there is a compressive (negative) strain at the bottom of the plate 15 (without foil here). Conversely, for the second bending direction "S2" depicted in FIG 2C, there is a compressive (negative) strain on the foil 10 above the neutral axis "N", while there is a tensile (positive) strain at the bottom of the plate 15.

As will be appreciated, the further away the foil 10 is from the neutral axis "N" for a respective bending direction, the more the foil may be stretched or compressed as a result of said bending (assuming the foil does not slip). For example, the distance of the neutral axis "N" away from the foil may be influenced e.g. by the thickness of the flexible plate 15 and/or its stretchability/compressibility compared to the foil.

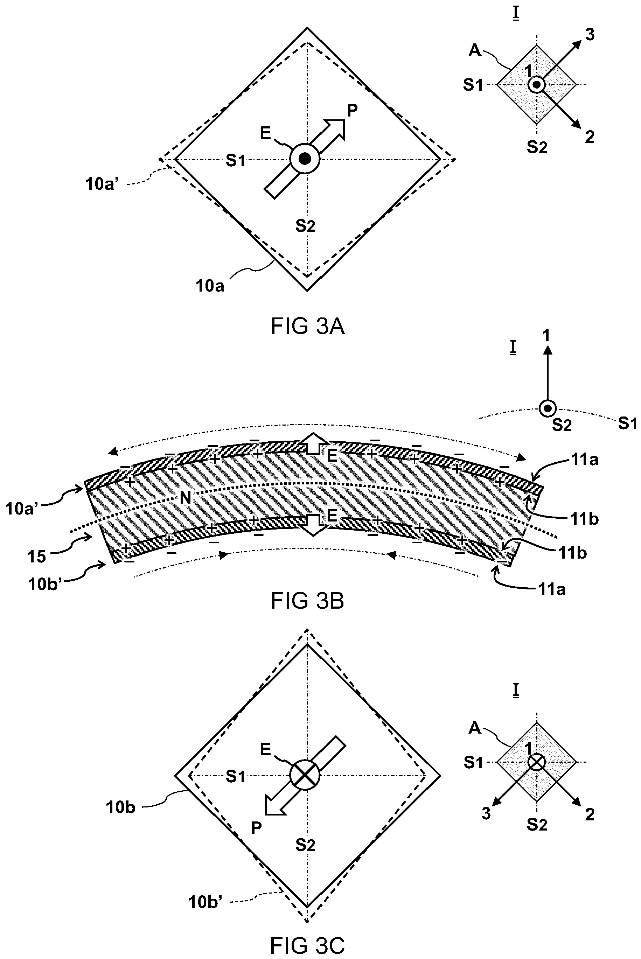

FIGs 3A-3B illustrate pieces foil 10a', 10b' on both sides of a flexible plate 15. FIG 3B illustrates a cross-section view is illustrated of the stack along the diagonal first bending direction "S1". FIG 3A illustrates a top view of the top foil 10a' being stretched along the first bending direction "S1". FIG 3C illustrates a top view of the bottom foil 10b' being stretched along the second bending direction "S2";

In some embodiments, e.g. as shown in FIG 3B, the piezoelectric foil 10 is adhered to both a top side and a bottom side of the plate 15. In a symmetric or near-symmetric arrangement piezoelectric foil is adhered to both sides of the flexible plate, the neutral axis "N" is typically at the center of the plate. So the neutral axis "N" may be maximally distanced from either foil providing optimal operation.

In some embodiments, as illustrated by FIGs 3A and 3C, the bottom foil 10b may be oppositely polarized "P" (from the same top view). This is also illustrated by the opposite polarization direction 3 of the respective insets "I". For example, the opposite polarization may result from the same foil being wrapped around the plate 15 (not shown here). Advantageously, electrodes 11a, 11b, can be applied on either sides of the foil, as shown, and optionally interconnected to combine like charges indicated by "+" and "-".

FIG 4A and 4B illustrate multiple layers of piezoelectric foil 10a' attached to a flexible plate 15. Preferably, as shown in both embodiments, the stack of foil layers 10a' comprises intermediate layers to prevent short circuiting the opposite charges "+" and "-" accumulated on subsequent layers.

In some embodiments, as shown in FIG 4A, the intermediate layers comprise non-conductive intermediate layers 10i, e.g. of similar material as the flexible plate 15, or other electrically insulating material. For example, the insulating layer may be formed by an adhesive layer with sufficient thickness to prevent short circuiting..

In other or further embodiments, as shown in FIG 4B, the intermediate layers also comprise piezoelectric material but e.g. with an opposite polarization so the like charges may actually accumulate there between. For example, as shown, a stack of piezoelectric foils is formed by alternating layers 10D', 10L' of piezo electric material having different chirality L,D.

FIG 5A illustrates a method of forming a transducer 100, as described herein, by adhering a piezoelectric foil 10 to a flexible plate 15.

According to some aspects, the present disclosure relates to a method for actuating a piezoelectric foil exhibiting shear piezoelectric effect, wherein the method comprises engaging the foil to undergo saddle shape deformation. In some embodiments, as shown, the foil 10 is provided from a roll 10R. In another or further embodiment, the foil 10 may be provided from an elongate sheet of material. In a preferred embodiment, the piezoelectric foil 10 is wrapped around the flexible plate 15. The foil can be wrapped many times around the plate. Preferably, the wrapping is sufficiently tight to prevent slipping of the layers, e.g. by sufficient friction or adhesion between the layers. In some embodiments, the foil 10 being wrapped around the plate 15 may comprise layers 10D,10L with alternating chirality. For example, the first piezoelectric layer comprises Poly($_L$-lactic acid) film and the second piezoelectric layer comprises Poly($_D$-lactic acid) film. Also other materials with similar properties can be used.

FIG 5B illustrates adhering the same type of foil 10a,10b at orthogonal polarization directions 3 by crossing the foils. This may have an advantage of needing only one type of foil, though perhaps at the cost of some convenience.

FIG 6A schematically illustrates a transducer 100 formed by a piezoelectric foil 10 wrapped around a flexible plate 15. While the schematic figure illustrates only a few layers of foil, in reality the foil 10 may be wrapped many times around the plate 15. For example, a stack of multiple layers of piezoelectric foil can be formed, e.g. having more than ten, twenty, thirty, fifty, hundred, or more layers.

Typically, the individual foil thickness "TF" of the piezoelectric foil 10 may be relatively low, e.g. less than one millimeter, preferably less than hundred micrometers, more preferably, less than fifty micrometers, e.g. between ten and thirty micrometers, or less. Typically, the individual foil thickness "TF" is much less than the plate thickness "TP" of the flexible plate 15, e.g. by a factor two, five, ten, or even a hundred. For example, the flexible plate 15 is at least half a millimeter thick, preferably at least one millimeter. Even with multiple foil layers, the total stack thickness "TS" of the foil layers is preferably on the same order or less than the plate thickness. For example, a length of two meters of foil is wrapped around a flexible square plate with dimensions 34x34 x2 mm resulting in a total thickness of 3 mm. Of course also other dimensions can be envisaged.

In one embodiment, e.g. as shown, respective electrode connections 11a,11b are formed on the exposed sides 15a,15b of the foil 10 wrapped around the flexible plate 15.

FIG 6B illustrates a stack of alternating piezoelectric layers and corresponding electrodes 11a,11b. For example, such stack may be formed by the wrapped foil as shown in FIG 6A, or a stack of foils can be formed in any other way such as FIG 4B.

In some embodiments, the foil 10 comprises first and second electrode layers 11a,11b with the piezoelectric material "M" sandwiched between the electrode layers. In a preferred embodiment, e.g. as shown, a conductive surface formed by the first electrode layer 11a extends beyond a surface of the piezoelectric material "M" on one side 15a of the foil. Most preferably, a conductive surface formed by the second electrode layer

11b extends beyond a surface of the piezoelectric material "M" on another side 15b of the foil.

For example, from a particular viewpoint, a conductive top surface forming the first electrode layer 11a extends on a left side of a length of foil and a conductive bottom side forming the second electrode layer 11b extends on a right side of the length of foil. Advantageously, the extended conductive surfaces of the electrodes 11a, 11b on opposite sides 15a,15b of the flexible plate 15 may form an easy way to connect the electrodes to a circuit (here schematically illustrated by "V"), particularly when the extended foil is wrapped or rolled around the flexible plate 15. For example, as shown, all exposed electrodes 11a on one side 15a of the foil may be electrically interconnected, and all exposed electrodes 11b on the other side 15a of the foil may be interconnected. While the conductive electrodes may extend beyond the surface of the piezoelectric material "M", optionally, the extended part may be supported by a non-conducive material and/or capping the sides of the piezoelectric material "M" against inadvertent electrical connection while allowing connection to the respective electrodes 11a, 11b.

In the embodiment shown, a first of the alternating electrodes is provided on top of the first type of piezoelectric layer 10L while the second of the alternating electrodes is provided between the first type of piezoelectric layer 10L and the second type of piezoelectric layer 10D. For example, using different types of piezoelectric layers may cause respective electric fields EL and ED in opposite directions while bending the stack along the two opposing bending directions "S1" and "S2", as described herein. This may correspond to electrical charges "+", "-" accumulating at the respective electrodes, as desired. Alternative to using different types of electrodes, as shown, one of the layers 10L, 10D may be replaced by a electrically insulating layer, e.g. according to FIG 4A, or otherwise. So it will be appreciated that many combinations and variations can be envisaged.

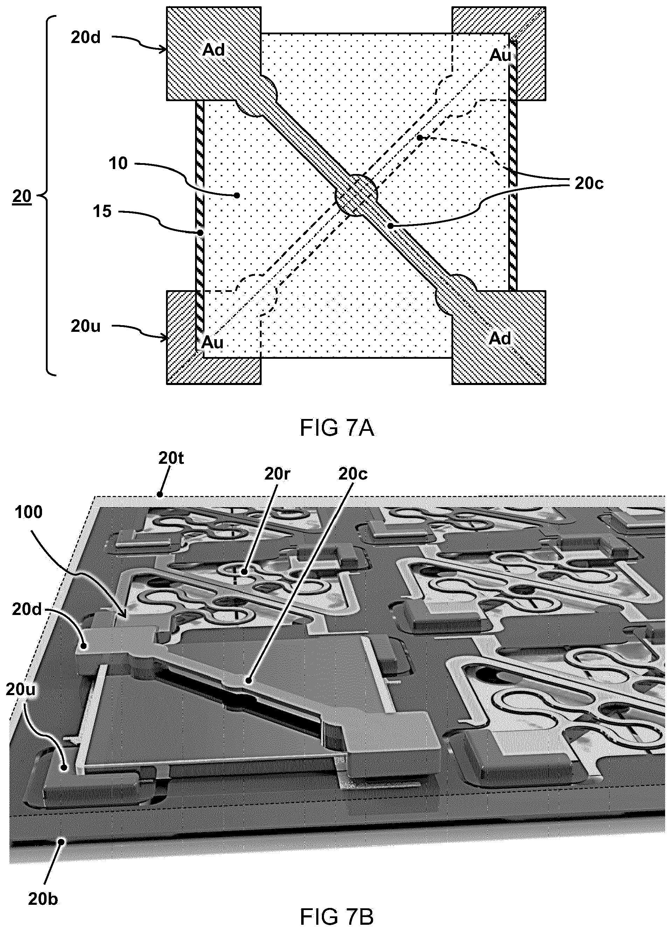

FIG 7A schematically illustrates an actuating structure 20 for actuating the foil 10 and/or flexible plate 15.

In a preferred embodiment, the transducer 100 comprises a square shaped stack formed by the piezoelectric foil 10 wrapped multiple times around a square shaped flexible plate 15. Most preferably, the actuating structure 20 is configured to engage corners of the square shaped stack to press or depress the stack into a saddle shape deformation.

In one embodiment, as shown, the actuating structure 20 may be configured to press (and/or pull) adjacent corners 20d,20u in opposite directions, e.g. up and down respectively. In another or further embodiment, as shown, the across lying or opposing corners may be pushed by the actuating structure 20 in the same direction. For example, the first set of actuation points "Au" may be disposed in one set of opposing corners of the square, and the second set of actuation points "Ad" may be disposed in the other set of opposing corners.

In one embodiment, e.g. as shown, the actuating structure 20 comprises cross-bars 20c connecting opposing corner-engaging points of the actuating structure 20. As shown, the crossbars on the top and the bottom of the piezoelectric stack preferably cross each other orthogonally, i.e. at or near ninety degree angles. This may allow simple inwards actuation on the actuating structure from either sides of the foil to be transformed into a saddle shape deformation of the foil there between.

FIG 7B illustrates a photograph of an extended sensor surface with multiple transducers 100.

According to some aspects, a sensor device may comprise a plurality of the described piezoelectric transducers 100 as sensing elements. In one embodiment, the sensor device comprises an actuating bottom surface 20b and an actuating top surface 20t (indicated by dashed lines here). In the embodiment, the plurality of the piezoelectric transducers 100 may be arranged between the bottom and top actuating surfaces 20b,20t. Preferably, each transducer comprises a respective actuating structure 20. In some embodiments, as shown a respective actuating structure in one or more transducers 100 comprises a respective resilient structure 20r which bends with the piezo stack to further guide the desired (saddle) deformation.

Alternatively, or in addition to a sensing element, the transducer 100 can also be used as energy harvester. Optionally, a rectifying circuit (not shown) may be connected to the respective electrodes to accumulate charges on both bending directions. Alternatively, or in addition, the transducer 100 may also function as an actuator, e.g. by applying an electric field, a corresponding motion may be effected.

Alternatively, or in addition to deforming a flat plate into a saddle shape, of course the reverse deformation may also be applied. For example, a foil 10 may be adhered to a saddle shaped flexible plate 15 and actuated into a flat shape to undergo saddle shape deformation. It may also be possible to actuate the shape from one saddle shape to another saddle shape, e.g. wherein initially a first set of opposing corners is up and the second set of corners is down, which corners are then pushed or pulled in the inverse saddle configuration where the first set of opposing corners is down and the second set of opposing corners is up.

According to some embodiments a simple method is provided to fabricate a transducer by using a flexible plate and tightly rolling the piezoelectric foil around the plate. In this way a multilayer stack can be created. The amount of layers can be very high and depends on the application and the amount of energy which needs to be harvested. The layers within this roll/stack preferably strongly adhere to each other and to the plate. It will be appreciated that i this plate is deformed into a horse saddle shape, the whole foil is loaded uniformly in shear (except from some boundary effects) and no part of the foil is loaded opposite such that it will dissipate the energy generated by the other part of the foil. The device can be applied in a situation where there is compression. When actuated, it will deform the device into a saddle shape and create a shear load in the piezoelectric material.

According to some embodiments, a flexible plate is provided of some kind of isolator (e.g. polymer) with a relatively low elastic modulus. For example, a PLLA/PDLA foil is delivered in a width of 30-35 mm. In that case the plate may be approximately square with a side length of 35 mm. For example, the piezoelectric film consists of two laminated layers: PLLA and PDLA. This film can be laminated/rolled tightly around the square. Preferably the piezoelectric film adheres well to the plate and well to each other. Delamination may reduce the energy harvesting capacity. Alternatives are to replace e.g. the PDLA foil with an alternative isolator. As the PDLA foil also harvests energy, this can reduce the energy harvesting capacity of the device. Instead of deforming the plate into a saddle shape, it can also be envisage to manufacture a core plate into the shape of a saddle and laminate. If this plate is flattened due to the compressive load, it will generate energy in a similar way as mentioned before

For the purpose of clarity and a concise description, features are described herein as part of the same or separate embodiments, however, it will be appreciated that the scope of the invention may include embodiments having combinations of all or only some of the features described. For example, while embodiments were shown for saddle shape deformation, also alternatives may be envisaged by those skilled in the art having the benefit of the present disclosure for achieving a similar function and result.. While actuation in many of the described embodiments may be particular efficient when undergoing saddle shape deformation, this is not always necessary to achieve at least some beneficial effect. For example a flexible plate with one or more layers of foil, such as particularly a foil with a zero degree cut or fold wrapped multiple times around a flexible plate can also be actuated primarily or exclusively in one bending direction. This can still provide substantial manufacturing benefit. The various elements of the embodiments as discussed and shown offer certain advantages, such as efficient manufacturing and actuating of devices with material exhibiting shear piezoelectric effects. Of course, it is to be appreciated that any one of the above embodiments or processes may be combined with one or more other embodiments or processes to provide even further improvements in finding and matching designs and advantages. It is appreciated that this disclosure offers particular advantages to piezoelectric sensors, and in general can be applied to any other piezoelectric device.

In interpreting the appended claims, it should be understood that the word "comprising" does not exclude the presence of other elements or acts than those listed in a given claim; the word "a" or "an" preceding an element does not exclude the presence of a plurality of such elements; any reference signs in the claims do not limit their scope; several "means" may be represented by the same or different item(s) or implemented structure or function; any of the disclosed devices or portions thereof may be combined together or separated into further portions unless specifically stated otherwise. Where one claim refers to another claim, this may indicate synergetic advantage achieved by the combination of their respective features. But the mere fact that certain measures are recited in mutually different claims does not indicate that a combination of these measures cannot also be used to advantage. The present embodiments may thus include all working combinations of the claims wherein each claim can in principle refer to any preceding claim unless clearly excluded by context.

## Claims

1. A piezoelectric transducer (100) comprising

   - a piezoelectric foil (10) with a piezoelectric material (M) exhibiting a shear piezoelectric effect ($d_{14}$), wherein the piezoelectric material (M) is polarized (P) in a polarization direction (3) in plane (A) with the foil (10) to generate an electric field (E) in a field direction (1) normal to the plane (A) of the foil (10) between a top surface (At) and a bottom surface (Ab) of the foil (10) when the foil (10) is sheared in plane (A) of the foil (10) in a shearing direction (4) about the field direction (1); and
   - an actuating structure (20) configured to actuate the foil (10) with actuation forces (Fu,Fd) applied at respective actuation points (Au,Ad) in respective actuation directions (U,D) to bend the foil (10) along at least one bending direction (S1, S2) diagonal to the polarization direction (3) of the foil (10).

2. The transducer according to claim 1, wherein the actuating structure (20) is configured to actuate the foil (10) according to a saddle shape deformation, wherein the foil (10) is bent in two opposing bending directions (S1,S2), wherein the two bending directions (S1,S2) are orthogonal to each other and both diagonal to the polarization direction (3).

3. The transducer according to claim 2, wherein the actuating structure (20) is configured to apply a first set of actuation forces (Fu) in a first actuation direction (U) normal to the plane (A) of the foil (10), and a second set of actuation forces (Fd) in a second actuation direction (D) opposite to the first actuation direction (U).

4. The transducer according to claim 3, wherein the first set of actuation forces (Fu) is applied to a first set of separate actuation points (Au) defining the first bending direction (S1) there between, wherein the second set of actuation forces (Fd) is applied to a second set of separate actuation points (Ad) defining the second bending direction (S2) there between, wherein the second bending direction (S2) crosses orthogonally with the first bending direction (S1) at a saddle point (S0) of the actuated foil (10').

5. The transducer according to claim 4, wherein, during saddle shape deformation, the deformed foil (10') is elongated along the first bending direction (S1) and compressed along the second bending direction (S2) compared to the flat foil (10).

6. The transducer according to claim 5, wherein the polarization direction (3) is along a length (L1) of the foil, wherein the foil (10) is cut and/or folded back on itself along a width (L2) of the foil by a cut and/or fold line which is orthogonal to the length (L1) of the foil.

7. The transducer according to claim 6, wherein the foil (10) is polarized by drawing the foil (10) along the length (L1), wherein the foil (10) comprises a piezoelectric polymer with elongate molecules which align with the drawing direction

8. The transducer according to any of the preceding claims, wherein the piezoelectric foil (10) is adhered to a flexible plate (15).

9. The transducer according to any of the preceding claims, wherein a respective neutral axis (N) for bending a combined stack comprising one or more layers of foil (10) adhered a flexible plate (15) along the first and/or second bending directions (S1,S2) lies within the flexible plate (15).

10. The transducer according to any of the preceding claims, wherein the piezoelectric foil (10) is adhered to both a top side and a bottom side of a flexible plate (15)

11. The transducer according to any of the preceding claims, wherein the piezoelectric foil (10) is wrapped around a flexible plate (15).

12. The transducer according to any of the preceding claims, wherein a stack of piezoelectric foils is formed by alternating layers (10D', 10L') of piezo piezoelectric material (M) having different chirality (L, D).

13. The transducer according to any of the preceding claims, wherein the foil (10) comprises first and second electrode layers (11a,11b) with the piezoelectric material (M) sandwiched between the electrode layers, wherein a conductive surface formed by the first electrode layer (11a) extends beyond a surface of the piezoelectric material (M) on one side (15a) of the foil, and a conductive surface formed by the second electrode layer (11b) extends beyond a surface of the piezoelectric material (M) on another side (15b) of the foil.

14. The transducer according to any of the preceding claims, wherein the transducer (100) comprises a square shaped stack formed by the piezoelectric foil (10) wrapped multiple times around a square shaped flexible plate (15), wherein the actuating structure (20) is configured to engage corners of the square shaped stack in opposing directions (U,D) to press the stack into the saddle shape deformation.

15. A sensor or energy harvesting device comprising a plurality of the piezoelectric transducers (100) according to any of the preceding claims.

FIG 1A

FIG 1B

FIG 2A

FIG 2B

FIG 2C

FIG 3A

FIG 3B

FIG 3C

FIG 4A

FIG 4B

FIG 5A

FIG 5B

FIG 6A

FIG 6B

FIG 7A

FIG 7B

Europäisches Patentamt
European Patent Office
Office européen des brevets

# EUROPEAN SEARCH REPORT

Application Number

EP 18 19 9304

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 2 696 163 A1 (MURATA MANUFACTURING CO LTD [JP]) 12 February 2014 (2014-02-12) | 1,8-10, 13,15 | INV. H01L41/113 H01L41/083 |
| Y | * paragraphs [0065] - [0084]; figures 1-4 * <br> * paragraphs [0093] - [0100]; figure 7 * | 11,12 | |
| X | WO 2018/008572 A1 (MURATA MANUFACTURING CO LTD [JP]) 11 January 2018 (2018-01-11) | 1,8,13, 15 | |
| Y | * paragraphs [0013] - [0049]; figures 1-7 * | 11,12 | |
| Y | TAJITSU Y ET AL: "Development of new force sensor using super-multilayer alternating laminated film comprising piezoelectric poly(l-lactic acid) and poly(d-lactic acid) films in the shape of a rectangle with round corners", JAPANESE JOURNAL OF APPLIED PHYSICS, vol. 56, 10PG03, 28 September 2017 (2017-09-28), XP055579109, ISSN: 0021-4922, DOI: 10.7567/JJAP.56.10PG03 * section 2; figures 1, 2 * | 11,12 | |
| A | US 2 463 109 A (JAFFE HANS) 1 March 1949 (1949-03-01) * column 7, lines 39-66; figure 3 * * column 8, lines 58-75; figure 9 * | 1-7,14, 15 | |
| A | DE 27 39 735 A1 (PHILIPS NV) 16 March 1978 (1978-03-16) * page 7, line 23 - page 10, line 25; figure 1 * | 1-7 | |

TECHNICAL FIELDS SEARCHED (IPC)

H01L
G01L

The present search report has been drawn up for all claims

| Place of search | Date of completion of the search | Examiner |
|---|---|---|
| Munich | 9 April 2019 | Köpf, Christian |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 18 19 9304

This annex lists the patent family members relating to the patent documents cited in the above-mentioned European search report.
The members are as contained in the European Patent Office EDP file on
The European Patent Office is in no way liable for these particulars which are merely given for the purpose of information.

09-04-2019

| Patent document cited in search report | | Publication date | Patent family member(s) | | Publication date |
|---|---|---|---|---|---|
| EP 2696163 | A1 | 12-02-2014 | CN | 103492832 A | 01-01-2014 |
| | | | CN | 105352428 A | 24-02-2016 |
| | | | CN | 107742670 A | 27-02-2018 |
| | | | EP | 2696163 A1 | 12-02-2014 |
| | | | EP | 2781886 A2 | 24-09-2014 |
| | | | EP | 2982938 A1 | 10-02-2016 |
| | | | JP | 5831542 B2 | 09-12-2015 |
| | | | JP | 5839091 B2 | 06-01-2016 |
| | | | JP | 5880645 B2 | 09-03-2016 |
| | | | JP | 5907220 B2 | 26-04-2016 |
| | | | JP | 6191717 B2 | 06-09-2017 |
| | | | JP | 2014240842 A | 25-12-2014 |
| | | | JP | 2015057598 A | 26-03-2015 |
| | | | JP | 2015057822 A | 26-03-2015 |
| | | | JP | 2016177802 A | 06-10-2016 |
| | | | JP WO2012137897 A1 | | 28-07-2014 |
| | | | US | 2014049137 A1 | 20-02-2014 |
| | | | US | 2017186939 A1 | 29-06-2017 |
| | | | WO | 2012137897 A1 | 11-10-2012 |
| WO 2018008572 | A1 | 11-01-2018 | NONE | | |
| US 2463109 | A | 01-03-1949 | GB | 634775 A | 29-03-1950 |
| | | | US | 2463109 A | 01-03-1949 |
| DE 2739735 | A1 | 16-03-1978 | DE | 2739735 A1 | 16-03-1978 |
| | | | FR | 2364544 A1 | 07-04-1978 |
| | | | JP | S5335492 A | 01-04-1978 |
| | | | NL | 7610124 A | 15-03-1978 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **ANDO et al.** *Japanese Journal of Applied Physics,* 2012, vol. 51, 09LD14